Europäisches Patentamt

European Patent Office

Office européen des brevets

(19)

(11) Numéro de publication : **0 162 737**
**B1**

(12) **FASCICULE DE BREVET EUROPÉEN**

(45) Date de publication du fascicule du brevet :
**15.06.88**

(51) Int. Cl.⁴ : **H 01 L 29/60**, **G 11 C 17/00**

(21) Numéro de dépôt : **85400658.2**

(22) Date de dépôt : **02.04.85**

(54) **Point-mémoire électriquement effaçable et reprogrammable, comportant une grille flottante au-dessus d'une grille de commande.**

(30) Priorité : **06.04.84 FR 8405484**

(43) Date de publication de la demande :
**27.11.85 Bulletin 85/48**

(45) Mention de la délivrance du brevet :
**15.06.88 Bulletin 88/24**

(84) Etats contractants désignés :
**DE FR GB IT NL**

(56) Documents cités :
**WO-A-83 /031 67**
**CA-A- 1 119 299**
**PATENTS ABSTRACTS OF JAPAN, vol. 6, no. 155 (E-125) [1033], 17 août 1982**

(73) Titulaire : **SGS-THOMSON MICROELECTRONICS S.A.**
**101, bld Murat**
**F-75016 Paris (FR)**

(72) Inventeur : **Guillaumot, Bernard**
**THOMSON-CSF SCPI 173, bld Haussmann**
**F-75379 Paris Cedex 08 (FR)**
Inventeur : **Laurens, Michel**
**THOMSON-CSF SCPI 173, bld Haussmann**
**F-75379 Paris Cedex 08 (FR)**

(74) Mandataire : **Guérin, Michel et al**
**THOMSON-CSF SCPI 19, avenue de Messine**
**F-75008 Paris (FR)**

EP 0 162 737 B1

## Description

La présente invention concerne les mémoires à semiconducteurs, du type EEPROM, c'est-à-dire électriquement effaçable et reprogrammables (mémoires non volatiles).

On connaît de telles mémoires, par exemple d'après le brevet US-A-4 203 158, qui décrit un point-mémoire comportant une grille flottante isolée dans laquelle on peut injecter et stocker de manière non volatile des électrons qui agissent sur la tension de seuil d'un transistor de lecture dont le canal est recouvert par la grille flottante, elle-même recouverte par une grille de commande. L'injection d'électrons se fait à travers une couche d'isolant très mince séparant la grille flottante d'une zone fortement dopée du substrat, une différence de potentiel importante (de l'ordre de 20 volts) étant appliquée entre la grille de commande et la zone dopée et se transmettant par influence capacitive entre la grille flottante et la zone dopée. Selon la quantité d'électrons piégée dans la grille flottante, il sera possible ou impossible, en mode de lecture, de rendre le transistor de lecture conducteur par application d'une tension de quelques volts sur la grille de commande.

On se reportera à un autre état de la technique constitué par la demande WO-A-8 303 167 dans laquelle il est décrit un point-mémoire selon la première partie de la revendication 1.

La présente invention a pour but d'améliorer les mémoires EEPROM à grille flottante, et, plus précisément, d'obtenir :

— un point-mémoire d'encombrement aussi réduit que possible, car la taille du point-mémoire individuel réagit directement sur la taille globale de la puce de circuit ingégré incorporant la mémoire et elle limite la capacité (en nombre de points-mémoire) des mémoires que l'on peut réaliser avec un rendement de fabrication acceptable,

— un point-mémoire susceptible de subir, sans dégradation excessive de ses performances, un nombre élevé de cycles d'inscriptions et effacements.

Bien entendu, parmi les autres buts de l'invention, il y a aussi le désir de réaliser le point-mémoire selon un procédé simple et de préférence compatible avec les technologies usuelles de fabrication.

Alors que dans la technique conventionnelle la grille flottante s'étendait au-dessus de toute la longueur de canal du transistor de lecture, et la grille de commande était séparée de la région de canal par la grille flottante qui était en effet interposée entre la région de canal et la grille de commande, l'invention part d'une structure dans laquelle au-dessus de la région de canal, la grille flottante s'étend au-dessus de la grille de commande sauf sur une partie de la longueur du canal. Dans cette partie, le canal n'est recouvert que par la grille flottante sur toute sa longueur ; on notera qu'on appelle « longueur » de canal la dimension qui s'étend entre source et drain, et « largeur » la dimension dans le sens transversal, même si la largeur est parfois plus grande que la longueur. Selon l'invention, on prévoit que la petite zone d'injection en dehors du transistor de lecture recouverte par une couche isolante très mince et par la grille flottante est une région semiconductrice de type N⁻ faiblement dopée, limitée, à l'aplomb d'au moins un bord de la grille flottante sur la zone d'injection, par une zone de type N⁺ fortement dopée.

Avec cette structure, on obtient un point-mémoire facile à réaliser, d'encombrement acceptable et de durée de vie accrue, pour des raisons que l'on expliquera plus loin.

D'autre caractéristiques et avantages de l'invention apparaîtront à la lecture de la description détaillée qui suit et qui est faite en référence aux dessins annexés dans lesquels :

— la figure 1 représente symboliquement la constitution d'un point-mémoire selon l'invention,

— la figure 2 représente en coupe transversale, selon la ligne tiretée brisée A-A de la figure 3, la structure du point-mémoire selon l'invention,

— la figure 3 représente une vue de dessus du point-mémoire, les métallisations, les couches d'isolation sur lesquelles elles reposent et les couches de passivation étant supposées retirées ou parfaitement transparentes.

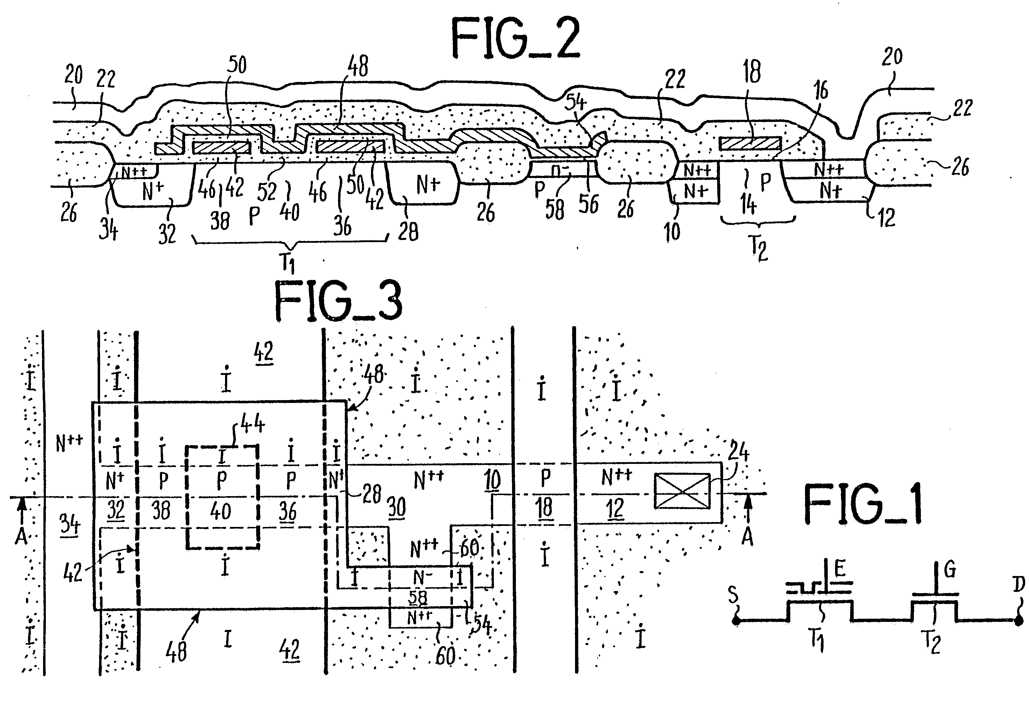

Le point-mémoire comprend essentiellement un transistor MOS de mémorisation (dit aussi transistor de lecture) T1, à grille flottante, en série avec un transistor MOS de sélection T2 (figure 1).

Par exemple, les sources S des transistors de lecture T1 d'une même colonne de points-mémoire sont toutes réunies, et les drains D des transistors de sélection T2 d'une même ligne sont également tous réunis. Les grilles G des transistors T2 de sélection d'une même colonne sont toutes réunies, de même que les grilles de commande E des transistors de lecture T1 d'une même colonne.

La structure physique du point-mémoire va être détaillée en référence aux figures 2 et 3.

On notera que la coupe de la figure 2 est faite selon une ligne brisée A-A de la figure 3.

Sur la figure 3, compte-tenu de la difficulté de représentation des vues de dessus de ce type, on a représenté ;

— par un trait tireté mixte la ligne de coupe A-A,

— par un trait fin continu ou tireté (selon que la ligne est directement visible ou est au-dessous d'une couche qui la masque) les lignes de contour des régions d'isolant épais, entourant des zones semiconductrices actives ; ces zones semiconductrices ont été repérées par les lettres P, N⁺, N⁺⁺, N⁻ indiquant leur type et intensité de dopage, même aux endroits où ces zones sont recouvertes de couches (grilles de silicium polycristallin) qui les masquent ; les zones d'isolant épais ont de même été désignées par la lettre I même là où elles sont recouvertes par d'autres couches ; là où elles ne sont pas recouvertes et sont donc directement visibles en vue de dessus, les zones isolantes sont représentées par une constellation de points ;

— par un trait continu d'épaisseur moyenne le contour de la grille flottante (qui n'est d'ailleurs nulle part masquée dans cette structure selon l'invention) ; et

— par un trait plus épais que tous les autres, continu là où il n'est pas masqué, tireté là où il est masqué, le contour des grilles de commande des deux transistors T1 et T2.

Le transistor de sélection T2 est parfaitement classique et ne nécessite pas de commentaire particulier ; il comprend une région de source 10 de type $N^+$, plus fortement dopée encore dans sa partie supérieure ($N^{++}$), une région de drain 12 similaire à la région de source et séparée d'elle par une région de canal 14 de type P recouverte d'une couche isolante mince 16 (oxyde de silicium de quelques dizaines de manomètres (centaines d'angströms)) elle-même recouverte d'une grille de commande 18 en silicium polycristallin. Une ligne métallique 20 vient en contact avec la région de drain 12 et est isolée du reste du point-mémoire par une couche isolante 22 sur laquelle elle repose (sur la figure 3, la ligne métallique 20 et la couche 22 ont été ôtées pour simplifier le dessin, et seule la zone de contact de la ligne 20 avec le drain 12 a été représentée en 24).

La grille 18 est constituée en réalité par une colonne de silicium polycristallin reliant les grilles des transistors T2 d'une même colonne de points-mémoire. La ligne métallique 20 relie aussi les drains des transistors T2 d'une même ligne de points-mémoire.

Source, drain, et canal du transistor T2 constituent une région semiconductrice active délimitée par de l'oxyde isolant épais désigné par 26 sur la figure 2 et par la lettre I sur la figure 3.

L'isolant épais 26 (I) délimite aussi les régions semiconductrices actives (source, drain, canal, zone d'injection, colonne de masse diffusée) du transistor de lecture T1 ; le contour des zones active est, on le rappelle, représenté par un trait fin continu ou interrompu sur la figure 3.

Le transistor de lecture T1 est constitué de la manière suivante : son drain est constitué par une région fortement dopée ($N^+$) 28 qui est en fait le prolongement de la région de source 10 du transistor de sélection T2 comme on le voit très bien sur la figure 3 alors que ce n'est pas visible sur la figure 2. On peut même dire plus précisément que la région de drain du transistor T1 comprend la région 28 de type $N^+$ immédiatement adjacente à la région de canal, et une région encore plus dopée 30 qui est la même que la région 10 (pas d'oxyde épais entre les régions 10 et 30), la distinction entre les régions 28 et 30 provenant en fait du procédé de fabrication utilisé, et ne résultant que du fait que, comme on le verra, la grille flottante du transistor T1 déborde (au-dessus de la région 28) par rapport à la grille de commande et constitue un masque protégeant cette région 28 lors du dopage de formation des régions $N^{++}$ 10 et 30.

Sur la figure 2, seule la région 28 est visible car la ligne de coupe A-A choisie ne passe pas à travers la région 30.

La région de source du transistor T1 est constituée aussi par une double région : région $N^+$ 32 là où la source est recouverte par un débordement de la grille flottante par rapport à la grille de commande, région $N^{++}$ 34 encore plus dopée, là où il n'y a de protection ni par la grille flottante ni par la grille de commande. La région 34 est en fait une colonne diffusée $N^{++}$ reliant les sources des transistors des points-mémoire d'une même colonne.

La région de canal du transistor T1, de type P, est la zone semiconductrice qui sépare la région 28 de la région 32 en dehors bien entendu des régions d'oxyde épais I (26). Cette zone a été décomposée, uniquement pour les besoins de la description, en trois parties : zone 36 adjacente à la région 28 sur toute la largeur du canal, et recouverte par une partie de la grille de commande, zone 38 adjacente à la région 32 sur toute la largeur du canal et recouverte par une autre partie de la grille de commande, et zone 40 entre les zones 36 et 38 sur toute la largeur du canal, non recouverte par la grille de commande mais recouverte par la grille flottante uniquement.

La grille de commande 42 du transistor T1 est constituée par un premier niveau de silicon polycristallin formant une colonne reliant les grilles de commande des transistors T1 des points-mémoire d'une même colonne, cette colonne de silicium polycristallin présentant une ouverture 44, rectangulaire par exemple, au-dessus de toute la zone centrale 40 de canal. De part et d'autre de cette ouverture, la grille de commande 42 recouvre les zones latérales 36 et 38 du canal. Le contour de la grille 42 et de son ouverture 44 est représenté en traits particulièrement épais sur la figure 3.

Il est à noter que la grille de commande 42 du transistor T1 et la grille de commande 18 du transistor T2 sont constituées par le même premier niveau de silicium polycristallin et sont gravées simultanément.

La grille de commande 42 du transistor T1 est isolée du substrat par une couche isolante mince 46 qui est en fait réalisée en même temps que la couche équivalente 16 du transistor T2 (oxyde de silicium de quelques dizaines de nanomètres (centaines d'angströms)).

La grille flottante 48 du transistor de lecture T1 est constituée par un deuxième niveau de silicium polycristallin et recouvre la grille de commande 42 non seulement dans toute la région de canal mais encore sur une partie importante de la grille de commande là où celle-ci s'étend sur l'oxyde épais 26, de manière que la capacité diélectrique entre les deux grilles soit importante. Les grilles 42 et 48 sont séparées par une couche isolante mince 50 (quelques dizaines de nanomètres (centaines d'angströms)).

De plus, la grille flottante recouvre totalement la zone centrale 40 du canal qui n'est pas recouverte par la grille de commande, et elle est séparée de cette zone par une couche mince isolante 52 (quelques centaines d'angströms).

Enfin, la grille flottante 48 comporte une extension 54 qui vient recouvrir totalement, en étant séparée d'elle par une couche isolante très mince 56 (quelques nanomètres (dizaines d'angströms) d'oxyde de silicium par exemple), une petite zone dite « d'injection » 58, faiblement dopée, de type $N^-$ (dopage inférieur à $10^{17}$ atomes/cm³ par exemple) ; la zone d'injection 58 $N^-$ est limitée latéralement d'une part par de l'oxyde épais 26, et d'autre part, sensiblement à l'aplomb d'au moins un bord de l'extension 54 de la grille flottante, par une extension 60 des régions 10 et 30 de type $N^{++}$.

Cette structure est réalisée selon le processus suivant (sur substrat de silicium) :

— formation classique des régions d'oxyde épais 26 par oxydation fine, dépôt de nitrure de silicium, élimination du nitrure par gravure au-dessus des zones d'oxyde épais 26, implantation éventuelle (non représentée) de type P dans ces zones, oxydation épaisse (de l'ordre de 1 μm), et élimination du nitrure ;

— nettoyage de la surface, formation de l'oxyde de grille 16, 46 (65 nm (650 angströms) par exemple), implantation éventuelle du type P ou N selon les transistors (non représentée) pour ajuster le dopage des régions de canal (transistors enrichis ou déplétés) des transistors T1 et T2 ou d'autres transistors du circuit intégré incorporant les points mémoire ;

— dépôt du premier niveau de silicium polycristallin avec dopage pendant ou après le dépôt ;

— gravure du silicium polycristallin pour définir les grilles de commande 18 et 42 avec notamment la formation des ouvertures 44 ; élimination de l'oxyde mince de grille là où il n'est pas recouvert de silicium polycristallin ;

— oxydation mince du silicium monocristallin et du silicium polycristallin, sur une épaisseur de l'ordre de 70 nm (700 angströms) par exemple, pour former l'oxyde 50 et 52 ;

— masquage par une résine des ouvertures 44 des grilles de commande ainsi que des zones d'injection 58, ainsi enfin que de zones entières du substrat qui n'ont pas besoin de subir l'implantation qui va suivre immédiatement après ; ce masque n'est pas critique au point de vue des tolérances de précision d'alignement ;

— implantation ionique de type $N^+$ définissant les régions de source et drain 10, 12, 28, 32 ; le silicium monocristallin subit l'implantation partout où il n'est pas protégé par l'oxyde épais 26 ou par le premier niveau de silicium polycristallin ou par la résine ;

— nouveau masque du substrat par une résine recouvrant les ouvertures 44 et découvrant les zones d'injection 58 (masque non critique) ;

— implantation de type $N^-$ dans les zones d'injection 58 ;

— mise à nu du silicium monocristallin là où il n'est pas protégé par la résine, c'est-à-dire essentiellement dans les zones d'injection 58 ; enlèvement de la résine ;

— oxydation très mince du silicium mais à nu (quelques nanomètres (dizaines d'angströms), par exemple 12 nm (120 angströms)) pour former la couche 56 ;

— dépôt du deuxième niveau de silicium polycristallin, dopage, et gravure de ce deuxième niveau pour définir la grille flottante 48 qui déborde latéralement de la grille de commande 42, qui recouvre entièrement l'ouverture 44 de celle-ci, et qui présente une extension 54 au-dessus de la zone d'injection 58 ;

— formation d'un isolant par dépôt ou oxydation thermique ;

— implantation ionique de type $N^{++}$ dans les régions de source et de drain 10, 12, 30, 34, 60, les régions 32 et 28 étant protégées par le débordement de la grille flottante ;

— formation de la couche isolante 22 par dépôt à basse température suivi d'un fluage ;

— gravure de cette couche 22 dans les zones de contact 24 ;

— métallisation, gravure (ligne 20 notamment) passivation, ouverture de plots de contact pour l'accès extérieur au circuit intégré.

Ce processus est tout à fait similaire, bien qu'il en diffère légèrement, à celui qui permettrait de réaliser un point-mémoire de la technique antérieure.

Le fonctionnement du point-mémoire est le suivant : un point-mémoire est sélectionné en lecture, écriture ou effacement, par le transistor T2 dont la grille est portée à un potentiel qui le rend conducteur.

1. En écriture

La source 32-34 du transistor T1 est laissée en haute impédance ; le drain 12 du transistor T2 est mis à la masse. La grille de commande 42 du transistor T1 est porté à un potentiel élevé positif (15 à 20 volts) ; il se produit, par effet tunnel à travers l'oxyde très mince 56, une injection d'électrons de la zone $N^-$ 58 (au potentiel de la masse) vers la grille flottante dont le potentiel est tiré par la grille de commande 42, par influence capacitive, à un potentiel proche de celui de la grille de commande (d'autant plus proche que le rapport de la capacité grille flottante/grille de commande à la capacité grille flottante/substrat est plus élevée, d'où la disposition avec large recouvrement de la grille flottante sur la grille de commande).

La grille flottante se charge ainsi d'électrons qui sont piégés.

2. En effacement

Le substrat est porté à zéro volt, la grille de commande 42 également ; le drain 12 et la grille de sélection 18, donc les régions $N^{++}$ 10, 30, 60 sont portées à une tension positive de 15 à 20 volts.

Une évacuation d'électrons se produit en sens inverse à travers l'oxyde très mince 56, de la grille flottante vers le bord de la région 60 qui est sensiblement à l'aplomb du bord de la grille flottante et qui est même légèrement surplombé par ce bord compte tenu des diffusions latérales inévitables lors de la formation des zones $N^{++}$.

La grille de commande se décharge ainsi de ses électrons et peut même prendre une charge globale positive.

3. En lecture

On examine s'il circule ou non un courant lorsqu'on applique une tension entre drain du transistor T2 et source du transistor T1 (le transistor T2 étant conducteur si le point-mémoire est sélectionné) lorsque la grille de commande 42 du transistor T1 est portée à un potentiel de lecture de quelques volts par rapport à la source 34.

Si une quantité suffisante d'électrons a été piégée dans la grille flottante lors de l'écriture, les quelques volts appliqués à la grille de commande seront aptes à rendre conductrices les portions latérales de canal 36 et 38 mais ne parviendront pas à contre-balancer, par influence capacitive, la forte charge négative stockée par la grille flottante : cette charge bloque fortement la zone centrale de canal 40 que la grille flottante serait seule à pouvoir rendre conductrice.

Si au contraire la charge de la grille flottante a été évacuée lors d'une phase d'effacement, les quelques volts appliqués à la grille de commande 42 se transmettent par influence capacitive à la grille flottante qui rend le canal conducteur dans la région centrale 40 comme dans les régions latérales. On distingue ainsi deux états du point-mémoire.

Le fonctionnement est donc similaire à celui d'une mémoire à grille flottante conventionnelle, à l'exception du fait que le canal est divisé en plusieurs zones en série qui doivent toutes être rendues conductrices pour rendre l'ensemble conducteur, et du fait que selon l'invention l'injection se produit à travers une zone de type $N^-$ ; on va revenir ultérieurement sur ce deuxième point.

Il est très important de remarquer que l'efficacité de l'injection et du stockage d'électrons dans la grille résulte d'une part du rapport de capacités déjà mentionné (capacité entre grilles et capacité grille flottante/substrat), et d'autre part de la qualité de l'isolement de la grille flottante.

Or, pour assurer une durée de vie importante à la mémoire, il faut éviter de dégrader la couche très mince 56 et par conséquent injecter le nombre de charges estimé suffisant mais pas plus ni moins. D'autre part, il faut minimiser la surface du point-mémoire. Cette surface est pour une très grande part imposée par la nécessité d'augmenter le rapport de capacités mentionné ci-dessus. C'est pourquoi toute solution tendant à réduire la capacité grille flottante/substrat est en général plus avantageuse du point de vue de l'encombrement qu'une solution tendant à augmenter la capacité entre grille de commande et grille flottante.

Dans la présente structure, la capacité de la grille flottante par rapport au substrat est fortement diminuée par le fait que la grille de commande, toujours portée à un potentiel fixe, agit comme un écran entre la grille flottante et le substrat. Seules les parties de la grille flottante qui sont directement en regard du substrat (zones de débordement 28, 32, ouverture 44, extension 54 vers la zone d'injection) participeront à la valeur de la capacité, alors que dans la technique conventionnelle toute la grille flottante était en regard du substrat.

D'autre part, il se trouve que les procédés de fabrication d'oxyde mince et de silicium polycristallin sont tels que le silicium polycristallin présente une surface très lisse là où il repose sur de l'oxyde mince, mais présente des aspérités à sa partie supérieure (irrégularités de surface d'un polycristal). Dans la technique conventionnelle, il y avait donc des aspérités à la surface de la grille flottante en regard de la surface lisse de la grille de commande. Or, pendant l'injection d'électrons, au fur et à mesure que la grille flottante se charge négativement, elle se comporte de plus en plus comme une cathode émettant des électrons vers la grille de commande (anode) par les aspérités de sa surface. Il fallait donc prévoir un courant d'injection suffisant pour compenser cette perte.

Au contraire, dans la présente structure, les aspérités se trouvent du côté de l'anode (grille de commande), ce qui est beaucoup plus favorable. Il est donc possible de réduire le courant d'injection donc la dégradation du point-mémoire.

Pendant l'évacuation d'électrons de la grille flottante, le principe est le même et c'est toujours la grille flottante à surface inférieure lisse qui joue le rôle de cathode vis-à-vis de la grille de commande, tout au moins tant que la grille flottante n'acquiert pas une charge fortement positive. Mais, et c'est là une raison essentielle de l'utilisation, en tant que zone d'injection, d'une zone 58 de type $N^-$ limitée par une zone $N^{++}$ à l'aplomb du bord de la grille flottante, pendant cette évacuation d'électrons, il se trouve que le potentiel de la grille flottante, plus faible que celui des zones $N^-$ et $N^+$ (portées à 20 volts environ) induit dans la zone $N^-$, du fait qu'elle est très faiblement dopée, une couche supérieure complètement déplétée (zone de charge d'espace positive) qui réduit considérablement la capacité de l'extension 54 de la grille flottante par rapport au substrat. L'évacuation d'électrons continue à se produire, mais vers la zone $N^{++}$ 60 qui est sous le bord de la grille flottante et qui en est séparée par l'isolant très mince 56.

L'efficacité d'évacuation d'électrons hors de la grille flottante est donc fortement améliorée par l'augmentation du rapport de la capacité entre grilles à la capacité grille flottante/substrat.

Bien entendu, la structure qui a ainsi été décrite est transposable dans d'autres technologies de fabrication.

**Revendications**

1. Point-mémoire à transistor à grille flottante, dans lequel le transistor à grille flottante comprend une région de source (32, 34) (de type N), une région de drain (28, 30) (de type N), une région de canal (36, 38, 40) (de type P), une grille de commande (42), une grille flottante (48) recouvrant la région de canal et séparée d'elle ainsi que de la grille de commande par des couches isolantes minces (50, 52), et enfin une zone d'injection (58) où la grille flottante n'est séparée du substrat que par une couche isolante très mince (56), dans lequel, au-dessus de la région de canal, la grille flottante (48) s'étend au-dessus de la grille de commande (42) sauf sur une partie (40) de la longueur du canal, partie dans laquelle le canal est recouvert sur toute sa largeur uniquement par la grille flottante, caractérisé en ce que la zone d'injection recouverte par ladite couche isolante très mince (56) et par la grille flottante (48) est une région semiconductrice (58) de type N⁻, faiblement dopée, limitée, sensiblement à l'aplomb d'au moins un bord de la grille flottante située au-dessus de cette zone d'injection, par une zone de type N⁺ fortement dopée (60).

2. Point-mémoire selon la revendication 1, caractérisé en ce que la zone (60) de type N⁺ fortement dopée est une extension de la région de drain (30) du transistor.

## Claims

1. A memory point of the floating gate transistor type in which the floating gate transistor comprises a source zone (32, 34) (of N-type), a drain zone (28, 30) (of N-type), a channel zone (36, 38, 40) (of P-type), a control gate (42), a floating gate (48) covering the channel zone and separated from the latter and from the control gate by thin insulating layers (50, 52), and finally an injection zone (58) in which the floating gate is separated from the substrate only by a very thin insulating layer (56), in which, above the channel zone, the floating gate (48) extends over the control gate (42) except for a portion (40) of the length of the channel, portion in which the channel is covered over its entire width only by the floating gate, characterized in that the injection zone, covered by said very thin insulating layer (56) and by the floating gate (48), is a semiconductor zone (58) of N⁻-type and of a low doping rate, this zone being delimited, substantially above at least one edge of the floating gate situated above this injection zone, by a zone of N⁺-type and of a high doping rate (60).

2. A memory point according to claim 1, characterized in that the zone (60) of N⁺-type and of a high doping rate is an extension of the drain zone (30) of the transistor.

## Patentansprüche

1. Aus einem Transistor mit schwebendem Gate bestehender Speicherpunkt, in dem der Transistor mit schwebendem Gate eine Quellenzone (32, 34) (vom N-Typ), eine Drain-Zone (28, 30) (vom N-Typ), eine Kanalzone (36, 38, 40) (vom P-Typ), ein Steuer-Gate (42), ein schwebendes Gate (48), das die Kanalzone überdeckt und von dieser sowie dem Steuergate durch dünne isolierende Schichten (50, 52) getrennt ist, und schließlich eine Injektionszone (58) aufweist, in der das schwebende Gate vom Substrat nur durch eine sehr dünne isolierende Schicht (56) getrennt ist, wobei das schwebende Gate (48) sich oberhalb der Kanalzone über das Steuergate (42) hinweg erstreckt, mit Ausnahme eines Teils (40) der Länge des Kanals, in dem der Kanal über seine ganze Breite nur vom schwebenden Gate bedeckt ist, dadurch gekennzeichnet, daß die Injektionszone, die von der sehr dünnen isolierenden Schicht (56) und von dem schwebenden Gate (48) bedeckt ist, ein halbleitender Bereich (58) vom N⁻-Typ ist, der nur gering dotiert ist und gegenüber mindestens einem Rand des oberhalb dieser Injektionszone liegenden schwebenden Gates durch eine hochdotierte Zone vom N⁺-Typ (60) begrenzt ist.

2. Speicherpunkt nach Anspruch 1, dadurch gekennzeichnet, daß die hochdotierte Zone (60) vom N⁺-Typ eine Verlängerung der Drain-Zone (30) des Transistors ist.

# FIG_2

# FIG_3

# FIG_1

0 162 737